# EUROPÄISCHE PATENTSCHRIFT

(11) **EP 2 577 754 B1**
(45) Veröffentlichungstag und Bekanntmachung des Hinweises auf die Patenterteilung: **07.01.2015**
(21) Anmeldenummer: 11781727.0
(22) Anmeldetag: 04.05.2011
(51) Int. Cl.: H01L 33/48, H01L 33/52, H01L 33/60, H01L 33/54

(54) **OPTOELEKTRONISCHES BAUELEMENT UND VERFAHREN ZUR HERSTELLUNG EINES OPTOELEKTRONISCHEN BAUELEMENTS UND EINES VERBUNDS**
OPTOELECTRONIC COMPONENT AND METHOD FOR PRODUCING AN OPTOELECTRONIC COMPONENT, AND COMPOSITE
COMPOSANT OPTO-ÉLECTRONIQUE ET PROCÉDÉ DE FABRICATION D'UN COMPOSANT OPTO-ÉLECTRONIQUE ET D'UN COMPOSITE

(30) Priorität: 27.05.2010 DE 102010021791
(43) Veröffentlichungstag der Anmeldung: 10.04.2013
(73) Patentinhaber: OSRAM Opto Semiconductors GmbH, 93055 Regensburg (DE)
(72) Erfinder: JÄGER, Harald, 93049 Regensburg (DE); ZITZLSPERGER, Michael, 93047 Regensburg (DE); SCHNEIDER, Albert, 93107 Thalmassing (DE)
(74) Vertreter: Epping, Wilhelm
(86) Internationale Anmeldenummer: PCT/DE2011/001037
(87) Internationale Veröffentlichungsnummer: WO 2011/147399

(56) Entgegenhaltungen:
- WO-A1-2010/035206
- WO-A2-2009/075530
- JP-A- 2007 019 096
- US-A1- 2004 075 100
- US-A1- 2005 173 708
- US-A1- 2006 171 152
- US-A1- 2007 045 800
- US-A1- 2007 087 174
- US-A1- 2009 057 708

## Beschreibung

Die Erfindung betrifft ein optoelektronisches Bauelement mit einem Gehäuse und einem Halbleiterchip. Weiterhin betrifft die Erfindung ein Verfahren zum Herstellen eines solchen optoelektronischen Bauelements und ein Verfahren zur Herstellung eines Verbunds aus einer Mehrzahl von optoelektronischen Bauelementen.

Diese Patentanmeldung beansprucht die Priorität der deutschen Patentanmeldung 10 2010 021 791.3, deren Offenbarungsgehalt hiermit durch Rückbezug aufgenommen wird.

Optoelektronische Bauelemente mit einem Gehäuse und einem Halbleiterchip sind beispielsweise aus der Druckschrift DE 10 2005 020 908 A1 bekannt. Der Gehäusekörper wird dabei mittels Umgießen zweier Anschlussteile mit einer geeigneten Formmasse hergestellt, wobei der Halbleiterchip auf einem der Anschlussteile angeordnet ist.

Silikon weist insbesondere den Vorteil der Hochtemperaturbeständigkeit und UV-Strahlenbeständigkeit auf, hat jedoch den Nachteil der geringen mechanischen Bruchfestigkeit und hohen Materialkosten im Vergleich zu beispielsweise Epoxid. Epoxid dagegen weist zwar eine gute Temperaturbeständigkeit und geringe Materialkosten auf, hat jedoch eine schlechte UV-Strahlenbeständigkeit.

Bei herkömmlichen optoelektronischen Bauelementen mit Gehäusen aus Epoxid können aufgrund UV-Einstrahlungen Alterungseffekte im Gehäusematerial, im Wesentlichen an den Oberflächen und zu einem geringerem Teil im Volumenmaterial, entstehen. Derartige Alterungseffekte sind beispielsweise Vergilbung, Verfärbung, Versprödung und/oder Rissbildung des Gehäusematerials sowie Delamination von anhaftendem Vergussmaterial. Diese Alterungseffekte können sich beispielsweise durch die von dem Halbleiterchip emittierte Strahlung ergeben. Herkömmliche Bauelemente sind dadurch in ihrer Lebensdauer begrenzt, insbesondere wenn es für die Funktionsfähigkeit eines Bauelements erforderlich ist, dass die Oberfläche des Gehäusematerials intakt bleibt, etwa wenn eine Linse oder ähnliches aufgeklebt ist. Durch die Alterungseffekte werden das Aussehen und Erscheinungsbild sowie die mechanische Stabilität nachteilig beeinflusst. Während bei herkömmlichem schwarzem Epoxid als Gehäusematerial kein Helligkeitsverlust durch die Alterungseffekte auftritt, kann dies jedoch der Fall bei nicht-schwarzem, insbesondere hellem oder weißem Epoxid der Fall sein. Als Lebensdauer kann dann beispielsweise auch die Zeit definiert werden, in welcher die Helligkeit der emittierten Strahlung des Bauelements bis auf einen definierten Bruchteil des Anfangswerts absinkt.

Die Druckschrift WO 2010/035206 A1 betrifft ein Licht emittierendes Bauteil, das mit einer Beschichtung versehen ist.

In der Druckschrift JP 2007-019096 A ist ein Licht emittierendes Bauteil beschrieben.

Ein Licht emittierendes Bauteil findet sich auch in der Druckschrift WO 2009/075530 A2.

Die Reduktion von thermischen Belastungen auf einen Halbleiterlaser wird in der Druckschrift US 2007/0087124 A1 behandelt.

Es ist in der Druckschrift US 2005/0173708 A1 ein Licht emittierendes Bauteil offenbart, ebenso wie in der Druckschrift US 2006/0171152 A1.

In der Druckschrift US 2004/0075100 A1 findet sich ein Gehäuse für eine Leuchtdiode an einem Leiterrahmen.

Der Erfindung liegt die Aufgabe zugrunde, unter Vermeidung dieser Nachteile ein optoelektronisches Bauelement zu schaffen, das eine verminderte Degradation des Gehäusematerials und dadurch eine erhöhte Lebensdauer aufweist und gleichzeitig in der Herstellung, beispielsweise der Materialauswahl, geringe Kosten verursacht.

Diese Aufgabe wird durch ein optoelektronisches Bauelement und Verfahren zu dessen Herstellung mit den Merkmalen der unabhängigen Patentansprüche gelöst.

Vorteilhafte Weiterbildungen des Bauelements und des Verfahrens sind Gegenstand der abhängigen Ansprüche.

Erfindungsgemäß ist ein optoelektronisches Bauelement vorgesehen, das ein Gehäuse, mindestens einen in dem Gehäuse angeordneten Halbleiterchip und eine Vergussmasse aufweist. Der Halbleiterchip weist eine zur Erzeugung oder Detektion von elektromagnetischer Strahlung geeignete aktive Schicht auf. Die Vergussmasse umschließt den Halbleiterchip zumindest bereichsweise, wobei in der Vergussmasse reflektierende Partikel eingebettet sind.

Ein optoelektronisches Bauelement ist insbesondere ein Bauelement, das die Umwandlung von elektronisch erzeugten Energien in Lichtemission ermöglicht, oder umgekehrt. Beispielsweise ist das optoelektronische Bauelement ein strahlungsemittierendes oder strahlungsempfangendes Bauelement.

Der Halbleiterchip weist eine Strahlungsaustrittsseite auf, aus der die von dem Halbleiterchip emittierte Strahlung zum größten Teil austritt, wobei die Strahlungsaustrittsseite frei von Vergussmasse ist. Beispielsweise ist der Halbleiterchip ein oberflächenemittierender Chip, wobei die Vergussmasse Seitenflächen des Halbleiterchips direkt umgibt. Die von dem Halbleiterchip emittierte Strahlung tritt somit nicht durch die Vergussmasse, sondern kann direkt aus dem Bauelement ausgekoppelt werden.

Als reflektierende Partikel in der Vergussmasse finden beispielsweise besonders bevorzugt TiO₂-Partikel Verwendung. Diese reflektierenden Partikel sind gleichmäßig in der Vergussmasse verteilt. Die Vergussmasse, die den Halbleiterchip bereichsweise umschließt, bildet somit einen reflektierenden Verguss des Halbleiterchips.

Durch die Vergussmasse mit reflektierenden Partikeln wird die von dem Halbleiterchip emittierte Strahlung von dem Gehäuse derart reflektiert, dass die von dem Halbleiterchip emittierte Strahlung nicht bis zu dem Gehäusematerial vordringt. Insbesondere wird die von dem Halbleiterchip emittierte Strahlung vor Auftreffen dieser Strahlung auf dem Gehäusematerial mittels der reflektierenden Partikel in der Vergussmasse derart reflektiert, dass diese Strahlung aus dem Bauelement herausgeleitet wird. Dadurch kann mit Vorteil die Materialdegradation des Gehäusematerials, die durch den Einfluss der Strahlung des Halbleiterchips hervorgerufen werden kann, reduziert werden. Eine Degradation am Gehäuse, die sich zum Beispiel in einer Vergilbung oder Verfärbung, einer Versprödung, einer Delamination und/oder einer Rissbildung in dem Gehäuse zeigt, kann dadurch reduziert werden, wodurch sich mit Vorteil die Lebensdauer eines solchen Bauelements erhöht.

In einer Weiterbildung weist das Gehäuse eine Kavität auf, an deren Grundfläche ein Leiterrahmen angeordnet ist, auf dem der Halbleiterchip angeordnet ist, wobei in der Kavität die Vergussmasse eingebracht ist.

Die Vergussmasse mit reflektierenden Partikeln bedeckt das Gehäusematerial vorteilhafterweise zumindest teilweise. Dadurch kann der der schädigenden UV-Strahlung direkt ausgesetzte Anteil des Gehäusematerials minimiert werden. Dabei dient die Vergussmasse mit reflektierenden Partikeln nicht nur als Reflektor zur Erhöhung der gegebenenfalls gerichteten Lichtausbeute, sondern zugleich als Strahlenschutz für das alterungsanfällige Gehäusematerial.

Zur Herstellung des Gehäuses wird der Leiterrahmen vorzugsweise mittels beispielsweise Spritzguss, Spritzpressguss oder Pressguss mit dem Gehäusematerial umformt. Das Gehäuse ist demnach als so genanntes vorgefertigtes Gehäuse ausgebildet, beispielsweise als Premolded-Gehäuseform. Bei einer derartigen Bauform wird der Halbleiterchip nach der Herstellung des Gehäuses auf dem Leiterrahmen montiert.

Der Leiterrahmen weist vorzugsweise ein erstes elektrisches Anschlussteil und ein zweites elektrisches Anschlussteil auf. Über die elektrischen Anschlussteile ist der Halbleiterchip elektrisch kontaktiert. Der Halbleiterchip kann beispielsweise mit dem ersten Anschlussteil über eine Anschlussschicht, etwa eine elektrisch leitende Klebstoff oder eine Lötschicht, elektrisch leitend verbunden und/oder auf diesen befestigt sein. Mit dem zweiten Anschlussteil ist der Halbleiterchip vorzugsweise über einen Bonddraht leitend verbunden.

Der Leiterrahmen, der beispielsweise aus Kupfer sein kann, und insbesondere das erste und zweite Anschlussteil weisen in einer Weiterbildung eine Silberbeschichtung auf. Alternativ oder zusätzlich kann der Leiterrahmen auch eine Gold, eine NiPdAu- oder eine NiAu-Beschichtung aufweisen. Derartige Beschichtungen weisen wie auch Kupfer beispielsweise eine gute Haftung zu Epoxid auf. Durch die Vergussmasse mit reflektierenden Partikeln kann der überwiegende Teil der von dem Halbleiterchip emittierten Strahlung derart an den reflektierenden Partikeln reflektiert werden, dass dieser Anteil nicht auf die auf dem Leiterrahmen trifft, wodurch mit Vorteil ein Korrosionsschutz für die Beschichtung erzeugt werden kann.

Der Halbleiterchip ist vorzugsweise eine LED. Bevorzugt ist der Halbleiterchip eine Dünnfilm-LED. Als Dünnfilm-LED wird im Rahmen der Anmeldung eine LED angesehen, während dessen Herstellung das Aufwachssubstrat, auf den eine Halbleiterschichtenfolge, die einen Halbleiterkörper des Dünnfilmhalbleiterchips bildet, beispielsweise epitaktisch aufgewachsen wurde, abgelöst worden ist.

Alternativ kann der Halbleiterchip eine Fotodiode oder ein Fototransistor sein. In diesem Fall weist der Halbleiterchip eine zur Detektion von elektromagnetischer Strahlung geeignete aktive Schicht auf.

Die aktive Schicht des Halbleiterchips weist vorzugsweise eine Heterostruktur, insbesondere eine Doppelheterostruktur, eine Einfach- oder Mehrfachquantentopfstruktur auf. Mittels derartiger Strukturen, insbesondere einer Mehrfachquantentopfstruktur oder einer Doppelheterostruktur, können besonders hohe interne Quanteneffizienzen erzielt werden.

Bevorzugt enthält der Halbleiterchip, insbesondere die aktive Schicht, mindestens ein III/V-Halbleitermaterial, etwa ein Material aus den Materialsystemen InₓGa_{y}Al_{1-x-y}P, InₓGa_{y}Al_{1-x-y}N oder InₓGa_{y}Al_{1-x-y}As, jeweils mit 0 ≤ x, y ≤ 1, und x + y ≤ 1. III/V-Halbleitermaterialien sind zur Strahlungserzeugung im ultravioletten Spektralbereich (InₓGa_{y}Al_{1-x-y}N) über den sichtbaren Spektralbereich (InₓGa_{y}Al_{1-x-y}N, insbesondere für blaue bis grüne Strahlung, oder InₓGa_{y}Al_{1-x-y}P, insbesondere für gelbe bis rote Strahlung) bis in den infraroten Spektralbereich (InₓGayAl_{1-x-y}As) besonders geeignet.

In einer Weiterbildung ist auf der Vergussmasse eine Abdeckschicht angeordnet. Die Abdeckschicht weist dabei vorzugsweise keine reflektierenden Partikel auf. Die Abdeckschicht bildet demnach einen sogenannten klaren Verguss.

Die Abdeckschicht ist vorzugsweise der Strahlungsaustrittsseite des Halbleiterchips nachgeordnet. Weist das Gehäuse beispielsweise eine Kavität auf, in die der Halbleiterchip angeordnet ist, so ist die Kavität zumindest teilweise mit der Vergussmasse gefüllt, wobei die Abdeckschicht auf der Vergussmasse angeordnet ist. Dabei kann die Abdeckschicht das Gehäuse bündig mit der Oberseite des Gehäuses abschließen. Alternativ kann die Vergussmasse das Gehäuse bündig mit der Oberseite des Gehäuses abschließen, wobei in diesem Fall die Abdeckschicht auf der Fläche, die durch Oberseite des Gehäuses und Vergussmasse gebildet wird, angeordnet ist.

In einer Weiterbildung ist in der Abdeckschicht zumindest ein Konversionsstoff eingebettet. Vorzugsweise ist der Konversionsstoff gleichmäßig in dem Material der Abdeckschicht verteilt.

Der Halbleiterchip emittiert bevorzugt eine Primärstrahlung mit einer ersten Wellenlänge. Der Konversionsstoff in der Abdeckschicht absorbiert bevorzugt zumindest teilweise Strahlung der ersten Wellenlänge und emittiert eine Sekundärstrahlung einer zweiten Wellenlänge. Dadurch emittiert das Bauelement Mischstrahlung, die sowohl die Primärstrahlung des Halbleiterchips als auch die Sekundärstrahlung des Konversionsstoffs enthält. Durch eine gezielte Wahl des Konversionsstoffs kann eine Korrektur des Farborts der von dem Halbleiterchip emittierten Strahlung erfolgen, wodurch sich ein gewünschter Farbort der von dem Bauelement emittierten Strahlung ergibt.

Unter dem Farbort werden insbesondere die Zahlenwerte verstanden, die die Farbe des emittierten Lichts des Bauelements im CIE-Farbraum beschreiben.

Zudem kann die Abdeckschicht mehr als einen Konversionsstoff enthalten. Dadurch ergibt sich eine Mischstrahlung der von dem Bauelement emittierten Strahlung, die Primärstrahlung und mehrere Sekundärstrahlungen der mehreren Konversionsstoffe enthält.

Durch einen in der Abdeckschicht eingebrachten Konversionsstoff kann beispielsweise weißes Licht erzeugt werden. Ferner kann durch die Verwendung spezieller Konversionsstoffe, wie beispielsweise Nitride oder Silikate, durch Konversion der von dem Halbleiterchip emittierten Strahlung von dem Bauelement emittierte Strahlung in einen Wellenlängenbereich von grün bis rot erzeugt werden. Hierbei können die Farben je nach Mischverhältnis und Leuchtstoffcharakteristik in der Sättigung variieren.

Bei einer Weiterbildung des Bauelements ist die Abdeckschicht als Linse ausgebildet. Dabei kann die Linse refraktive oder diffraktive Eigenschaften aufweisen. Die Linse kann aufgemoldet sein, beispielsweise durch ein Formpressverfahren oder durch ein anderes Moldingverfahren zur Flüssigverarbeitung.

In einer Weiterbildung ragt der Halbleiterchip in vertikaler Richtung aus der Vergussmasse heraus. Die Strahlungsaustrittsseite des Halbleiterchips ist also nicht mit der Vergussmasse bedeckt. Bevorzugt ist die Strahlungsaustrittsseite zur Gehäuseoberseite zugewandt, wobei die Vergussmasse den Halbleiterchip seitlich direkt umgibt.

Als vertikale Richtung wird insbesondere die Richtung senkrecht zur Grundfläche des Gehäuses angesehen.

In einer Weiterbildung grenzt die Abdeckschicht direkt an die Vergussmasse an. Zwischen Abdeckschicht und Vergussmasse ist somit kein Abstand, wie beispielsweise Luft, angeordnet. Dabei unbeachtlich sind beispielsweise herstellungsbedingte Lufteinschlüsse zwischen Abdeckschicht und Vergussmasse.

In einer Weiterbildung ragt der Halbleiterchip in vertikaler Richtung in die Abdeckschicht hinein. Der Halbleiterchip ist somit mindestens bereichsweise von der Abdeckschicht in direktem Kontakt umgeben. Vorzugsweise ragt der Halbleiterchip mit der Strahlungsaustrittsseite in die Abdeckschicht hinein.

In einer Weiterbildung enthält das Gehäuse ein Epoxid, eine Epoxidpressmasse, oder PPA (Polyphthalamide). Epoxid weist insbesondere eine gute Temperaturbeständigkeit und geringe Materialkosten auf. Der schlechten UV-Strahlenbeständigkeit des Epoxidmaterials kann durch die Vergussmasse mit reflektierenden Partikeln entgegengetreten werden.

Das Gehäusematerial ist beispielsweise schwarz oder farbig ausgestaltet. Beispielsweise ist das Gehäusematerial mittels Ruß eingefärbt. Alternativ dazu kann das Gehäuse auch weiß eingefärbt sein.

Die Abdeckschicht weist vorzugsweise Silikon oder ein Hybridmaterial auf. Ein Hybridmaterial enthält beispielsweise Silikon und Epoxid oder eine ähnlich geeignete Mischung.

Die Vergussmasse enthält vorzugsweise Silikon.

Die Abdeckschicht, die beispielsweise ein Hybridmaterial oder Silikon enthält, weist eine gute Haftung zum Vergussmaterial aus Silikon auf. Dadurch ist es vorteilhafterweise nicht notwendig, zwischen der Abdeckschicht und der Vergussmasse einen Haftvermittler zu verwenden.

Durch das Gehäuse, in das eine Vergussmasse mit darin enthaltenen reflektierenden Partikeln eingebracht ist, ergeben sich unter anderem folgende Vorteile:
- Preisgünstige Herstellung aufgrund der Verwendung von kostengünstigen Pressmassen beispielsweise aus Epoxid für das Bauelementgehäuse, das auch für Anwendungen in der Allgemeinbeleuchtung nutzbar ist,
- Alterungsstabilität des Gehäuses aufgrund der reflektierenden Partikel in der Vergussmasse als Strahlenschutz sowie damit verbundene Lichtsteigerung und Korrosionsschutz für eine gegebenenfalls verwendete Silberbeschichtung oder zumindest ein Sichtschutz für angelaufenes Silber durch die Vergussmasse,
- robustes Bauelement aufgrund der Verwendung mechanisch stabiler Epoxidpressmassen als Gehäuse mit an Kupfer angepassten Temperaturausdehnungskoeffizienten und guter Haftung zu Kupfer, beispielsweise bei Verwendung eines Kupferleiterrahmens, wodurch eine hohe Bauelementzuverlässigkeit erzielt werden kann,
- Zuverlässigkeit aufgrund des Schichtaufbaus des Bauelements aus Kupferleiterrahmen mit Epoxidgehäuse, Vergussmasse aus Silikon beispielsweise mit TiO₂-Partikeln, darauf aufgebrachtes ungefülltes oder gegebenenfalls mit Konversionsstoff oder Diffusor gefülltes Silikon als Abdeckschicht, wodurch aufgrund dieses Mehrschichtenaufbaus ein schrittweises Anheben des Temperaturausdehnungskoeffizenten der einzelnen Komponenten ermöglicht wird, womit eine hohe Bauelementzuverlässigkeit und eine geringe Gefahr der Delamination erzielt werden kann.

Zudem lässt sich die Herstellung des erfindungsgemäßen Bauelements ohne wesentliche Änderungen des etablierten Prozesses und der Prozessfolge in diese integrieren. Vorteilhaft ist auch eine große Freiheit im Bauelement- und Prozessdesign mittels alternativ oder miteinander kombinierbarer Vergüsse, wie beispielsweise reflektierendem Verguss, Klarverguss sowie Volumenkonversion oder Linsenintegration.

Das Gehäuse des Bauelements kann nach Fertigstellung beispielsweise schwarz oder weiß ausgebildet sein, abhängig von der jeweils gewünschten Anwendung des Bauelements, zum Beispiel schwarz für Displayanwendungen mit hohem Kontrast.

In einem Verfahren zum Herstellen eines Bauelements aufweisend ein Gehäuse und einen Halbleiterchip wird das Gehäuse mittels eines Spritzpress- oder Spritzgussverfahrens hergestellt. Vorteilhafte Weiterbildungen des Verfahrens ergeben sich analog zu den vorteilhaften Weiterbildungen des Bauelements und umgekehrt.

Bevorzugt wird bei einem Verfahren zum Herstellen eines optoelektronischen Bauelements die Formgebung des Gehäuses mittels eines Werkzeugs durchgeführt, das eine geschlossene Form aufweist, wobei das Gehäuse zumindest teilweise in dem Werkzeug ausgehärtet wird. Bevorzugt wird anschließend das Gehäuse außerhalb des Werkzeugs nachgehärtet.

Bevorzugt wird ein geätzter oder gestanzter Leiterrahmen von dem Gehäusematerial mittels eines Spritzpress- oder eines Spritzgussverfahrens zumindest teilweise umhüllt. Bevorzugt weist das Gehäuse eine Kavität auf, an deren Grundfläche der Leiterrahmen frei von dem Gehäusematerial vorliegt. Besonders bevorzugt weist der Leiterrahmen ein erstes und ein zweites Anschlussteil auf, wobei der Halbleiterchip auf einem der Anschlussteile montiert ist und mittels eines Bonddrahtes elektrisch mit dem anderen Anschlussteil verbunden wird.

Bevorzugt wird in die Kavität des Gehäuses eine Vergussmasse eingebracht, wobei die Vergussmasse reflektierende Partikel aufweist. Besonders bevorzugt wird die Vergussmasse derart eingebracht, dass der Halbleiterchip die Vergussmasse in vertikaler Richtung überragt.

Besonders bevorzugt wird auf die Vergussmasse eine Abdeckschicht aufgebracht, in die der Halbleiterchip hineinragt. Vorzugsweise ragt die Strahlungsaustrittsseite in die Abdeckschicht hinein, wobei Vergussmasse und Abdeckschicht direkt aneinandergrenzen.

Bei einer Weiterbildung wird die Abdeckschicht mittels eines Formpressprozesses zu einer Linse geformt.

Bei einer Weiterbildung weist das Gehäuse eine Mehrzahl von Kavitäten auf, an deren Grundfläche jeweils ein Halbleiterchip aufgebracht wird, wobei das Gehäuse anschließend zu einzelnen Bauelementen zertrennt wird, sodass jedes separate Bauelement mindestens einen Halbleiterchip aufweist.

Zudem können Halbleiterchipteile mit einer bestimmten Anzahl von Halbleiterchips hergestellt werden. In diesem Fall weist eine Kavität eine Mehrzahl von Halbleiterchips auf. Dadurch können beispielsweise optoelektronische Bauelemente hergestellt werden, die eine Kombination aus Emitterchips und Detektorchips aufweisen.

In dem Verfahren können insbesondere Einzelbauteile oder ganze Arrays (Halbleiterchipzeilen mit einer bestimmten Anzahl an Halbleiterchips) hergestellt werden. Eine Herstellung des Bauelements in Großserie ist dadurch möglich, wodurch sich mit Vorteil die Herstellungskosten verringern.

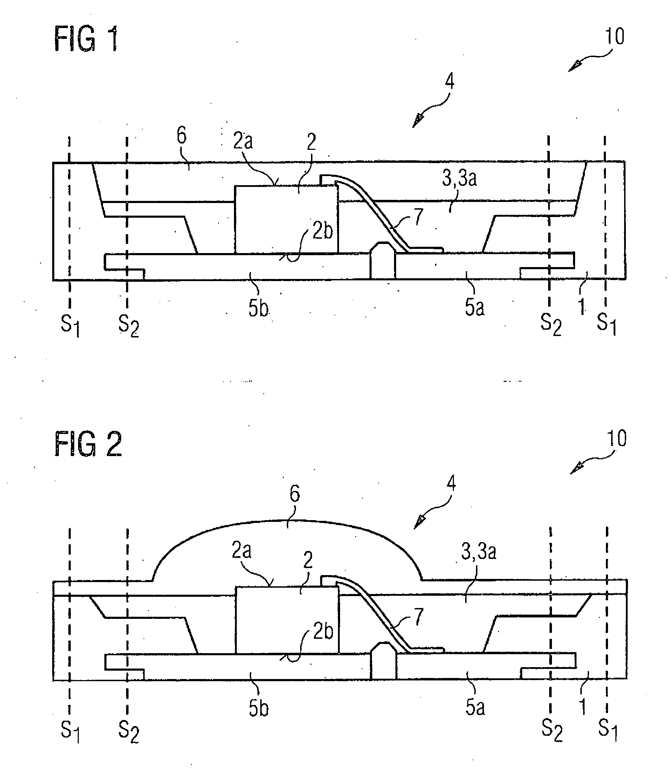

Weitere Merkmale, Vorteile, Weiterbildungen und Zweckmäßigkeiten des Bauelements und dessen Verfahren ergeben sich aus den im Folgenden in Verbindung mit den Figuren 1 und 2 erläuterten Ausführungsbeispielen.

Es zeigen:
- Figuren 1, 2: jeweils einen schematischen Querschnitt eines Ausführungsbeispiels eines erfindungsgemäßen Bauelements.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

In den Figuren 1 und 2 ist jeweils ein optoelektronisches Bauelement 10 dargestellt, das ein Gehäuse 1 und einen Halbleiterchip 2 aufweist. Das Gehäuse 1 weist eine Kavität 4 auf, in die der Halbleiterchip 2 angeordnet ist.

Das Gehäuse 1 weist einen Leiterrahmen 5a, 5b auf. Der Leiterrahmen 5a, 5b weist ein erstes 5a und ein zweites Anschlussteil 5b auf, die zur elektrischen Kontaktierung des Halbleiterchips 2 dienen. Die Anschlussteile 5a, 5b des Leiterrahmens sind voneinander durch Gehäusematerial elektrisch voneinander isoliert. Der Leiterrahmen 5a, 5b kann ein geätzter Leiterrahmen sein, der bevorzugt gedünnte Bereiche aufweist. Die gedünnten Bereiche des Leiterrahmens werden bevorzugt mittels eines Spritzpress- oder Spritzgussverfahrens mit dem Gehäusematerial umschlossen. Dadurch ergibt sich mit Vorteil eine Verankerung des Leiterrahmens in dem Gehäusematerial.

Der Halbleiterchip 2 kann mit dem ersten Anschlussteil 5b über eine Anschlussschicht, etwa eine elektrisch leitende Klebstoff- oder Lotschicht, elektrisch leitend verbunden und/oder auf diesem befestigt sein. Insbesondere ist der Halbleiterchip 2 mit einer Befestigungsseite 2b auf dem ersten Anschlussteil 5b befestigt. Mit dem zweiten Anschlussteil 5a ist der Halbleiterchip 2 bevorzugt über einen Bonddraht 7 elektrisch leitend verbunden. Der Bonddraht führt vorzugsweise von der Strahlungsaustrittsseite 2a des Halbleiterchips 2 zum zweiten Anschlussteil 5a.

Das Bauelement weist ein vorgeformtes Gehäuse auf, da beispielsweise auch als so genanntes Premolde-Package bezeichnet werden kann. Die Formgebung des Gehäuses 1 wird im Herstellungsprozess mittels eines Werkzeugs bestimmt, das eine geschlossene Form aufweist, wobei das Gehäuse in dem Werkzeug vorgehärtet und anschließend außerhalb des Werkzeugs nachgehärtet wird.

Der Halbleiterchip 2 weist eine zur Erzeugung oder zur Detektion von elektromagnetischer Strahlung geeignete aktive Schicht auf. Beispielsweise ist der Halbleiterchip 2 eine LED. Bevorzugt ist der Halbleiterchip 2 eine Dünnfilm-LED. Der Halbleiterchip 2 basiert bevorzugt auf einem Nitrid, einem Phosphid oder einem Arsenidverbindungshalbleiter.

In der Kavität 4 des Gehäuses ist eine Vergussmasse 3 angeordnet, die bevorzugt Silikon aufweist. Alternativ oder zusätzlich kann auch die Vergussmasse 3 ein Hybridmaterial mit Silikon und Epoxid oder ein Epoxid aufweisen. In der Vergussmasse 3 sind reflektierende Partikel, insbesondere TiO₂-Partikel 3a, gleichmäßig verteilt. Insbesondere wird das Gehäuse so weit mit der Vergussmasse gefüllt, dass das Gehäusematerial größtenteils mit der Vergussmasse bedeckt ist. Durch die in der Vergussmasse 3 eingebrachten reflektierenden Partikel 3a kann von dem Halbleiterchip 2 emittierte Strahlung in Richtung Strahlungsaustrittsfläche des Bauelements gelenkt werden. Dadurch trifft ein geringerer Anteil der von dem Halbleiterchip 2 emittierten Strahlung das Gehäuse 1, womit sich der Anteil der Strahlung, die direkt auf das Gehäusematerial trifft, minimiert. Dadurch lassen sich mit Vorteil Materialdegradationen des Gehäuses minimieren.

Die Vergussmasse mit darin enthaltenen reflektierenden Partikeln dient demnach sowohl als Reflektor zur Erhöhung der gegebenenfalls gerichteten Lichtausbeute des Bauelements sowie zum Strahlenschutz für das gegebenenfalls alterungsanfällige Gehäusematerial. Dadurch können kostengünstige Pressmassen, die anfällig für Strahlungsschäden sind, für das Bauelementgehäuse Verwendung finden. Insbesondere wird die schädigende UV-Strahlung, die auf das Gehäusematerial auftrifft, durch die so ausgebildete Vergussmasse reduziert.

Der Leiterrahmen 5a, 5b weist vorzugsweise Kupfer auf. Auf dem Leiterrahmen 5a, 5b kann beispielsweise eine Silberbeschichtung, eine Au-Beschichtung oder eine NiPdAu-Beschichtung Verwendung finden. Zudem kann als Gehäusematerial eine Epoxidpressmasse verwendet werden, die einen an Kupfer angepassten Temperaturausdehnungskoeffizienten und eine gute Haftung zu Kupfer aufweist, wodurch ein robustes Bauelement und eine hohe Bauelementzuverlässigkeit erzielt werden kann.

Bei Verwendung eines Leiterrahmens mit einer Beschichtung dient die Vergussmasse mit darin enthaltenen reflektierenden Partikeln zugleich als Korrosionsschutz oder zumindest als Sichtschutz bei einem korrodiertem Leiterrahmen.

Auf der Vergussmasse ist eine Abdeckschicht 6 angeordnet. In dem Ausführungsbeispiel der Figur 1 ist die Abdeckschicht 6 derart auf der Vergussmasse 3 angeordnet, dass die Abdeckschicht 6 mit der Oberseite des Gehäuses 1 bündig nach außen abschließt. Die Höhe des Gehäuses entspricht somit der Höhe der Vergussmasse zuzüglich der Abdeckschicht.

In der Abdeckschicht 6 kann ein Konversionsstoff enthalten sein, der die von dem Halbleiterchip 2 emittierte Strahlung in Strahlung einer anderen Wellenlänge emittiert. Dadurch kann ein Bauelement erzielt werden, das Mischstrahlung aus emittierter Strahlung des Halbleiterchips 2 und Konversionsstrahlung emittiert, beispielsweise weiße Strahlung. Die Abdeckschicht 6 dient in diesem Fall somit als Konversionsschicht.

Das Bauelement 10 weist einen Dreikomponentenschichtaufbau auf, enthaltend das Gehäuse 1, die Vergussmasse 3 und die Abdeckschicht 6. Dadurch kann mit Vorteil schrittweise der Temperaturausdehnungskoeffizient von Komponente zu Komponente angehoben werden. Beispielsweise weist das Gehäusematerial aus Epoxid einen kleinen Temperaturausdehnungskoeffizienten von 1 bis 18 ppm/°C auf, wohingegen die Abdeckschicht einen Temperaturausdehnungskoeffizienten bevorzugt von etwa 150 bis 300 ppm/°C aufweist.

Der Halbleiterchip 2 ragt bevorzugt in vertikaler Richtung aus der Vergussmasse 3 heraus. Bevorzugt weist der Halbleiterchip 2 eine Strahlungsaustrittsseite 2a auf, die entgegen der Befestigungsseite 2b liegt, und die frei von Vergussmasse ist. Insbesondere ist die Vergussmasse 3 seitlich von dem Halbleiterchip 2 angeordnet und umschließt diesen lateral vollständig.

Die Abdeckschicht 6 grenzt direkt an die Vergussmasse 3 an. Ein Abstand zwischen Abdeckschicht 6 und Vergussmasse 3 ist vorzugsweise nicht vorhanden. Unbeachtlich hierbei sind insbesondere herstellungsbedingte Lufteinschlüsse.

Der Halbleiterchip 2 ragt in vertikaler Richtung in die Abdeckschicht 6 hinein. Insbesondere umgibt die Abdeckschicht 6 den Halbleiterchip 2 zumindest bereichsweise. Vorzugsweise steht die Abdeckschicht 6 in direktem Kontakt mit der Strahlungsaustrittsseite 2a des Halbleiterchips 2. Von dem Halbleiterchip 2 emittierte Strahlung verlässt den Halbleiterchip demnach an der Strahlungsaustrittsseite 2a, und tritt durch die Abdeckschicht 6, bevor diese das Bauelement verlässt.

Das Gehäuse 1 enthält vorzugsweise ein Epoxid, eine Epoxidpressmasse oder PPA (Polyphthalamide). Die Abdeckschicht 6 enthält vorzugsweise Silikon oder ein Hybridmaterial. Die Vergussmasse 3 enthält bevorzugt Silikon.

Zusätzlich besteht die Möglichkeit, das erfindungsgemäße Bauelement in Großserie herzustellen (nicht dargestellt). Insbesondere kann dabei ein Verbund aus einer Mehrzahl der Bauelemente hergestellt werden. Dazu weist das Gehäuse 1 mehrere Kavitäten auf, an deren Grundfläche jeweils ein Anschlussteil eines Leiterrahmens frei von dem Gehäusematerial vorliegt und jeweils zumindest ein Halbleiterchip, also ein Halbleiterchip oder mehrere Halbleiterchips, auf dem Anschlussteil des Leiterrahmens einer Kavität aufgebracht wird. In die Kavitäten wird jeweils eine Vergussmasse eingebracht, wobei auf der Vergussmasse eine Abdeckschicht aufgebracht wird. Nach der Herstellung der optoelektronischen Bauelemente in dem Verbund kann der Verbund zu Einzelbauelementen oder zu Bauelementarrays einer bestimmten Größe vereinzelt werden, wobei jedes separate Bauelement zumindest einen Halbleiterchip aufweist. Zur Vereinzelung wird beispielsweise dazu in den in Figuren 1 und 2 dargestellten Schnittbereichen S1 oder S2 gesägt.

Das Ausführungsbeispiel der Figur 2 unterscheidet sich von dem Ausführungsbeispiel der Figur 1 durch die Anordnung sowie die Ausgestaltung der Abdeckschicht 6. In Figur 2 ist die Abdeckschicht 6 beispielsweise mittels eines Formpressverfahrens als Linse ausgebildet. Vorzugsweise ist die Linse dabei derart angeordnet, dass sie der Strahlungsaustrittsseite des Halbleiterchips 2 direkt nachgeordnet ist.

Entgegen dem Ausführungsbeispiel der Figur 1 weist das Bauelement der Figur 2 eine Vergussmasse 3 auf, die mit der Oberseite des Gehäuses 1 abschließt. Die Abdeckschicht 6 ist auf der flächig ausgebildeten Oberseite, die sich aus Gehäuseoberseite und Vergussmassenoberseite zusammensetzt, aufgebracht. Die Abdeckschicht 6 ist demnach nicht in der Kavität 4 des Gehäuses eingebracht, sondern sitzt auf der Kavität und schließt das Bauelement nach oben hin ab.

Im Übrigen stimmt das Bauelement der Figur 2 im Wesentlichen mit dem Bauelement der Figur 1 überein.

Bei den hier gezeigten optoelektronischen Bauelementen kann mit Vorteil das beispielsweise schwarze oder auch weiße oder andersfarbige Gehäuse durch die beispielsweise weiß erscheinende Vergussmasse vor Strahlung, insbesondere UV-Strahlung, geschützt werden.

Die Erfindung ist nicht durch die Beschreibung anhand der Ausführungsbeispiele auf diese beschränkt, sondern ist durch den Anspruchsbereich der angehängten Patentansprüche definiert.

## Patentansprüche

1. Optoelektronisches Bauelement (10) aufweisend ein Gehäuse (1), einen in dem Gehäuse (1) angeordneten Halbleiterchip (2) und eine Vergussmasse (3), wobei
- der Halbleiterchip (2) eine zur Erzeugung oder Detektion von elektromagnetischer Strahlung geeignete aktive Schicht aufweist,
- die Vergussmasse (3) den Halbleiterchip (2) zumindest bereichsweise umschließt,
- in der Vergussmasse (3) reflektierende Partikel (3a) eingebettet sind,
- der Halbleiterchip (2) in vertikaler Richtung aus der Vergussmasse (3) herausragt,
- die Vergussmasse (3) Seitenflächen des Halbleiterchips (2) direkt umgibt,
- auf der Vergussmasse (3) eine Abdeckschicht (6) angeordnet ist,
- die Abdeckschicht (6) direkt an die Vergussmasse (3) angrenzt,
- der Halbleiterchip (2) in vertikaler Richtung in die Abdeckschicht (6) hineinragt und von der Abdeckschicht (6) in direktem Kontakt umgeben ist, **dadurch gekennzeichnet, dass**
- schrittweise der Temperaturausdehnungskoeffizient von Gehäuse (1) zu Vergussmasse (3) zu Abdeckschicht (6) angehoben ist, und dass
- ein Gehäusematerial des Gehäuses (1) ein Epoxid mit einem Temperaturausdehnungskoeffizienten von 1 bis 18 ppm/°C aufweist und die Abdeckschicht (6) einen Temperaturausdehnungskoeffizienten von 150 bis 300 ppm/°C aufweist.

2. Optoelektronisches Bauelement nach Anspruch 1, wobei
- das Gehäuse (1) eine Kavität (4) aufweist, an deren Grundfläche ein Leiterrahmen (5a, 5b) angeordnet ist, auf dem der Halbleiterchip (2) angeordnet ist,
- die Vergussmasse (3) in der Kavität (4) eingebracht ist, und
- die Abdeckschicht (6) derart auf der Vergussmasse (3) angeordnet ist, dass die Abdeckschicht (6) mit einer Oberseite des Gehäuses (1) bündig nach außen abschließt und eine Höhe des Gehäuses (1) somit einer Höhe der Vergussmasse (3) zuzüglich der Abdeckschicht (6) entspricht.

3. Optoelektronisches Bauelement nach einem der vorhergehenden Ansprüche, wobei
in der Abdeckschicht (6) zumindest ein Konversionsstoff eingebettet ist, der die von dem Halbleiterchip (2) emittierte Strahlung in Strahlung einer anderen Wellenlänge umwandelt, sodass eine Mischstrahlung aus emittierter Strahlung des Halbleiterchips (2) und Konversionsstrahlung erzeugt wird und die Mischstrahlung weiße Strahlung ist.

4. Optoelektronisches Bauelement nach Anspruch 1, 2 oder 3, wobei
die Abdeckschicht (6) als Linse ausgebildet ist.

5. Optoelektronisches Bauelement nach einem der vorhergehenden Ansprüche, wobei
die reflektierenden Partikel (3a) TiO₂-Partikel sind, die in der Vergussmasse (3) gleichmäßig verteilt sind, sodass durch die Vergussmasse (3) mit den reflektierenden Partikeln (3a) die von dem Halbleiterchip (2) emittierte Strahlung nicht bis zu dem Gehäusematerial des Gehäuses (1) vordringt.

6. Optoelektronisches Bauelement nach zumindest Anspruch 2, wobei
der Leiterrahmen (5a, 5b) aus Kupfer gebildet ist und ein erstes und zweites Anschlussteil des Leiterrahmens (5a, 5b) eine Silberbeschichtung, eine Goldbeschichtung, eine NiPdAu-Beschichtung oder eine NiAu-Beschichtung aufweisend.

7. Optoelektronisches Bauelement nach einem der vorhergehenden Ansprüche, wobei
das Gehäuse (1) schwarz ausgebildet ist.

8. Optoelektronisches Bauelement nach einem der vorhergehenden Ansprüche, wobei
die Abdeckschicht (6) ein Silikon oder ein Hybridmaterial enthält.

9. Optoelektronisches Bauelement nach einem der vorhergehenden Ansprüche, wobei
das Gehäuse (1) PPA (Polyphthalamid) enthält.

10. Optoelektronisches Bauelement nach einem der vorhergehenden Ansprüche, wobei
die Vergussmasse (3) ein Silikon oder ein Hybridmaterial enthält.

11. Verfahren zum Herstellen eines optoelektronischen Bauelements (10) nach einem der vorhergehenden Ansprüche, wobei
das Gehäuse (1) mittels eines Spritzpress- oder Spritzgussverfahrens hergestellt wird.

12. Verfahren nach Anspruch 11, wobei
die Formgebung des Gehäuse (1) mittels eines Werkzeugs durchgeführt wird, das eine geschlossene Form aufweist, indem das Gehäuse (1) zumindest teilweise in dem Werkzeug ausgehärtet wird.

13. Verfahren nach Anspruch 11 oder 12, wobei in das Gehäuse (1) die Vergussmasse (3) derart eingebracht wird, dass der Halbleiterchip (2) die Vergussmasse (3) in vertikaler Richtung überragt.

14. Verfahren nach Anspruch 13, wobei
auf die Vergussmasse (3) eine Abdeckschicht (6) aufgebracht wird, in die der Halbleiterchip (2) hineinragt.

15. Verfahren zum Herstellen eines Verbunds aus einer Mehrzahl von Bauelementen nach einem der vorhergehenden Ansprüche 1 bis 10, wobei
- das Gehäuse (1) eine Mehrzahl von Kavitäten (4) aufweist, an deren Grundfläche jeweils zumindest ein Halbleiterchip (2) aufgebracht wird,
- in die Kavitäten (4) die Vergussmasse (3) mit reflektierenden Partikeln eingebracht wird, und
- das Gehäuse (1) anschließend zu einzelnen Bauelementen (10) zertrennt wird, sodass jedes separate Bauelement (10) mindestens einen Halbeiterchip (2) aufweist.

## Claims

1. Optoelectronic component (10) comprising a housing (1), a semiconductor chip (2) arranged in the housing (1) and a casting compound (3), wherein
- the semiconductor chip (2) comprises an active layer suitable for generating or detecting electromagnetic radiation,
- the casting compound (3) at least partially encloses the semiconductor chip (2),
- reflective particles (3a) are embedded in the casting compound (3),
- the semiconductor chip (2) protrudes from the casting compound (3) in the vertical direction,
- the casting compound (3) directly surrounds side surfaces of the semiconductor chip (2),
- a cover layer (6) is arranged on the casting compound (3),
- the cover layer (6) directly adjoins the casting compound (3),
- the semiconductor chip (2) protrudes in the vertical direction into the cover layer (6) and is surrounded by the cover layer (6) in direct contact, **characterized in that**
- the co-efficient of thermal expansion is increased stepwise from the housing (1) to the casting compound (3) to the cover layer (6) and **in that**
- a housing material of the housing (1) comprises an epoxide having a co-efficient of thermal expansion of 1 to 18 ppm/°C and the cover layer (6) has a co-efficient of thermal expansion of 150 to 300 ppm/°C.

2. Optoelectronic component according to Claim 1, wherein
- the housing (1) comprises a cavity (4) on the base surface of which a lead frame (5a, 5b) is arranged, on which the semiconductor chip (2) is arranged,
- the casting compound (3) is introduced into the cavity (4), and
the cover layer (6) is arranged on the casting compound (3) in such a way that the cover layer (6) terminates outwardly flush with an upper side of the housing (1), and a height of the housing (1) thus corresponds to a height of the casting compound (3) plus the cover layer (6).

3. Optoelectronic component according to either of the preceding claims, wherein
at least one conversion material is embedded in the cover layer (6) and converts the radiation emitted by the semiconductor chip (2) into radiation having a different wavelength, such that a mixed radiation comprising emitted radiation of the semiconductor chip (2) and conversion radiation is generated and the mixed radiation is white radiation.

4. Optoelectronic component according to Claim 1, 2 or 3, wherein
the cover layer (6) is formed as a lens.

5. Optoelectronic component according to one of the preceding claims, wherein
the reflective particles (3a) are TiO₂ particles distributed uniformly in the casting compound (3) such that through the casting compound (3) with the reflective particles (3a) the radiation emitted by the semiconductor chip (2) does not advance as far as the housing material of the housing (1).

6. Optoelectronic component according to at least Claim 2, wherein
the lead frame (5a, 5b) is formed from copper and a first and second terminal part of the lead frame (5a, 5b) comprising a silver coating, a gold coating, an NiPdAu coating or an NiAu coating.

7. Optoelectronic component according to one of the preceding claims, wherein
the housing (1) is embodied in a black fashion.

8. Optoelectronic component according to one of the preceding claims, wherein
the cover layer (6) contains a silicone or a hybrid material.

9. Optoelectronic component according to one of the preceding claims, wherein
the housing (1) contains PPA (polyphthalamide).

10. Optoelectronic component according to one of the preceding claims, wherein
the casting compound (3) contains a silicone or a hybrid material.

11. Method for producing an optoelectronic component (10) according to one of the preceding claims, wherein
the housing (1) is produced by means of an injection pressing or injection molding method.

12. Method according to Claim 11, wherein
the shaping of the housing (1) is carried out by means of a tool which comprises a closed shape, by at least partially curing the housing (1) in the tool.

13. Method according to Claim 11 or 12, wherein
the casting compound (3) is introduced into the housing (1) in such a way that the semiconductor chip (2) protrudes beyond the casting compound (3) in the vertical direction.

14. Method according to Claim 13, wherein
a cover layer (6), into which the semiconductor chip (2) protrudes, is applied onto the casting compound (3).

15. Method for producing a compound structure consisting of a multiplicity of components according to one of the preceding Claims 1 to 10, wherein
- the housing (1) comprises a multiplicity of cavities (4), on the base surface of which at least one semiconductor chip (2) is respectively applied,
- the casting compound (3) comprising reflective particles is introduced into the cavities (4), and
- the housing (1) is subsequently separated into individual components (10), in such a way that each separate component (10) comprises at least one semiconductor chip (2).

## Revendications

1. Composant opto-électronique (10) comportant un carter (1), une puce semi-conductrice (2) disposée dans le carter (1) et une masse fondue (3) ;
- la puce semi-conductrice (2) comportant une couche active adaptée pour produire ou détecter un rayonnement électromagnétique ;
- la masse fondue (3) englobant la puce semi-conductrice (2) au moins partiellement ;
- des particules réfléchissantes (3a) étant encastrées dans la masse fondue (3) ;
- la puce semi-conductrice (2) saillant dans la direction verticale hors de la masse fondue (3) ;
- la masse fondue (3) ceignant directement les surfaces latérales de la puce semi-conductrice (2) ;
- une couche de revêtement (6) étant disposée sur la masse fondue (3) ;
- la couche de revêtement (6) étant directement connexe à la masse fondue (3) ;
- la puce semi-conductrice (2) saillant vers l'intérieur dans la direction verticale dans la couche de revêtement (6) et étant entourée en contact direct de la couche de revêtement (6) ;
**caractérisé en ce que** :
- le coefficient de dilatation thermique du carter (1) par rapport à la masse fondue (3) en couche de revêtement (6) est soulevé par étapes ; et que
- un matériau de carter du carter (1) comporte une matière époxyde avec un coefficient de dilatation thermique de 1 à 18 ppm/°C et la couche de revêtement (6) comporte un coefficient de dilatation thermique de 150 à 300 ppm/°C.

2. Composant opto-électronique selon la revendication 1, **caractérisé en ce que** :
- le carter (1) comporte une cavité (4) au niveau de la surface de base de laquelle un cadre conducteur (5a, 5b) est disposé sur lequel la puce semi-conductrice (2) est disposée ;
- la masse fondue (3) est amenée dans la cavité (4) ; et
- la couche de revêtement (6) est disposée de telle sorte sur la masse fondue (3) que la couche de revêtement (6) se termine avec un côté supérieur du carter (1) en affleurement vers l'extérieur et une hauteur du carter (1) correspondant à une hauteur de la masse fondue (3) par rapport à la couche de revêtement (6).

3. Composant opto-électronique selon l'une quelconque des revendications précédentes, au moins une matière de conversion étant encastrée dans la couche de revêtement (6), ladite matière convertissant le rayonnement émis par la puce semi-conductrice (2) en rayonnement d'une autre longueur d'onde, de sorte qu'un rayonnement mélangé composé de rayonnement émis de la puce semi-conductrice (2) et de rayonnement de conversion est produit et que le rayonnement mélangé est un rayonnement blanc.

4. Composant opto-électronique selon la revendication 1, 2 ou 3, la couche de revêtement (6) prenant la forme d'un lentille.

5. Composant opto-électronique selon l'une quelconque des revendications précédentes, les particules réfléchissantes (3a) étant des particules TiO₂ régulièrement réparties dans la masse fondue (3), de sorte que le rayonnement émis par la puce semi-conductrice (2) ne ressorte pas avec les particules réfléchissantes (3a) jusqu'au matériau de carter du carter (1) à travers la masse fondue (3).

6. Composant opto-électronique selon au moins la revendication 2, le cadre conducteur (5a, 5b) étant constitué de cuivre et une première et deuxième partie de jonction du cadre conducteur (5a, 5b) comportant un revêtement d'argent, un revêtement d'or, un revêtement de NiPdAu ou un revêtement de NiAu.

7. Composant opto-électronique selon l'une quelconque des revendications précédentes, le carter (1) étant réalisé en noir.

8. Composant opto-électronique selon l'une quelconque des revendications précédentes, la couche de revêtement (6) contenant une silicone ou une matière hybride.

9. Composant opto-électronique selon l'une quelconque des revendications précédentes, le carter (1) contenant du PPA (polyphthalamide).

10. Composant opto-électronique selon l'une quelconque des revendications précédentes, la masse fondue (3) contenant une silicone ou une matière hybride.

11. Procédé de fabrication d'un composant opto-électronique (10) selon l'une quelconque des revendications précédentes, le carter (1) étant fabriqué à l'aide d'un procédé de moulage par injection ou de pressage par injection.

12. Procédé selon la revendication 11, la formation du carter (1) étant réalisée à l'aide d'un outil comportant une forme fermée, le carter (1) étant durci au moins en partie dans l'outil.

13. Procédé selon la revendication 11 ou 12, la masse fondue (3) étant amenée de telle sorte dans le carter (1) que la puce semi-conductrice (2) ressort de la masse fondue (3) dans la direction verticale.

14. Procédé selon la revendication 13, une couche de revêtement (6) dans laquelle la puce semi-conductrice (2) rentre étant appliquée sur la masse fondue (3).

15. Procédé de fabrication d'un composite composé d'une pluralité de composants selon l'une quelconque des revendications 1 à 10 :
- le carter (1) comportant une pluralité de cavités (4) au niveau de la surface de base desquelles respectivement au moins une puce semi-conductrice (2) est appliquée ;
- la masse fondue (3) dotée de particules réfléchissantes étant amenée dans les cavités (4) ; et
- le carter (1) étant ensuite divisé en composants individuels (10), de sorte que chaque composant (10) séparé comporte au moins une puce semi-conductrice (2).
